# EUROPEAN PATENT APPLICATION

(11) **EP 4 561 270 A1**
(43) Date of publication of application: **28.05.2025**
(21) Application number: 24214222.2
(22) Date of filing: 20.11.2024
(51) Int. Cl.: H05K 1/02, H05K 1/14, H05K 3/00

(54) **FLEXIBLE PRINTED CIRCUIT**

(30) Priority: 21.11.2023 IT 202300024717
(71) Applicant: Cisel S.r.l. - Circuiti Stampati Per Applicazioni Elettroniche, 60022 Castelfidardo (AN) (IT)
(72) Inventor: FIORETTI, Emanuela, 60022 Castelfidardo, ANCONA (IT)
(74) Representative: Gamba, Alessandro

(57) **Abstract**

The invention is a flexible printed circuit (1) for electrically connecting a first device (901) and a second device (902) comprised in an electronic assembly (900). The flexible printed circuit (1) extends between a first connection end (11) and a second connection end (12). Furthermore, the flexible printed circuit (1) comprises a support layer (101) and a conductive layer (102). The support layer (101) has elastic behavior, such that the flexible printed circuit (1) is elastically deformable between a resting configuration, wherein the first connection end (11) and the second connection end (12) are at a resting distance (Dr), and a working configuration, wherein the first connection end (11) and the second connection end (12) are at a working distance (Dl) different from the resting distance (Dr). Said flexible printed circuit (1) is able to elastically return to the resting configuration.

## Description

The present invention relates to a flexible printed circuit. Additionally, the present invention relates to an electronic assembly that comprises said flexible printed circuit. Furthermore, the present invention relates to a method for obtaining a flexible printed circuit.

In particular, the present invention is in the field of flexible printed circuits adapted to electrically connect two devices of an electronic assembly therebetween.

In the prior art, flexible printed circuit solutions are known that are used to electrically connect two or more devices of an electronic assembly. Said flexible printed circuits have a significant reliability limit.

A first problem encountered in the flexible circuits of the prior art is that of being unreliable in cases of application wherein there is mutual movement amongst the devices of the electronic assembly.

A further problem encountered in flexible circuits of the prior art, in cases of application wherein there is mutual movement amongst the devices, is linked to the fact that flexible circuits cause impediments to said mutual movement.

Moreover, the greater the number of movement repetitions, the more likely the possibility of causing a malfunction with the electronic assembly.

The object of the present invention is to fulfill the needs of the sector and to overcome the problems of the aforementioned prior art.

Such object is achieved by means of the flexible printed circuit claimed in claim 1. Furthermore, such object is also achieved by means of the electronic assembly according to claim 9. Furthermore, such object is also achieved by means of the method for obtaining the flexible printed circuit according to claim 12. The claims dependent thereupon seek protection for further features and entail further technical advantages.

In addition, further features and advantages of the invention will become clear from the description provided below of the preferred embodiments thereof given as non-limiting examples with reference to the accompanying figures, in which:
- Figures 1a and 1b show a perspective view of a flexible printed circuit according to a first embodiment in a resting configuration and in a working configuration, respectively;
- Figures 2a and 2b show a perspective view of a flexible printed circuit according to a second embodiment in a resting configuration and in a working configuration, respectively;
- Figures 3a and 3b show a perspective view of a flexible printed circuit according to a third embodiment in a resting configuration and in a working configuration, respectively;
- Figures 4a and 4b show a perspective view of a flexible printed circuit according to a fourth embodiment in a resting configuration and in a working configuration, respectively;

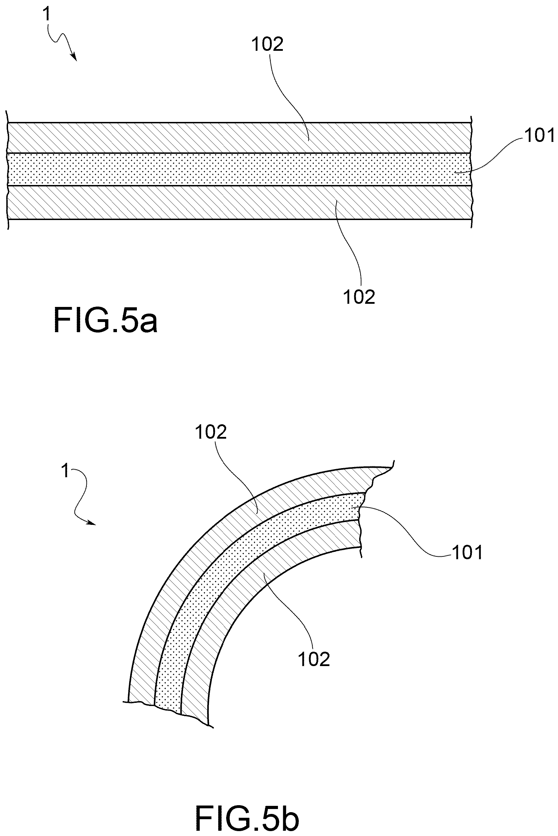

- Figures 5a and 5b show a cross-sectional side view of a flexible printed circuit according to a preferred embodiment in a resting configuration and in a working configuration, respectively;

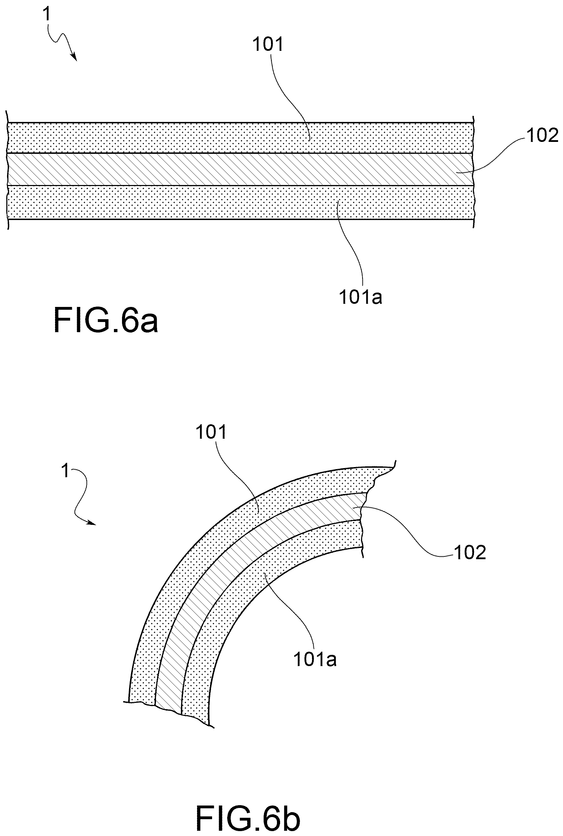

- Figures 6a and 6b show a cross-sectional side view of a flexible printed circuit according to a further preferred embodiment in a resting configuration and in a working configuration, respectively;

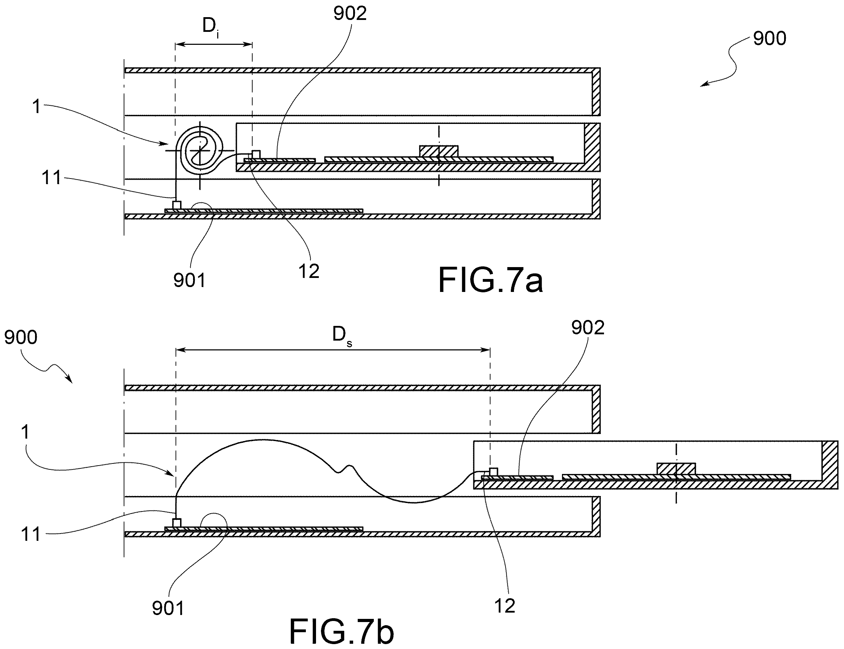

- Figures 7a and 7b show cross-sectional side views of an electronic assembly according to the invention in an initial configuration and in a stress configuration, respectively;
- Figure 8 shows a top view of a rigid-flexible printed circuit obtained by means of a connection between a rigid circuit and a flexible printed circuit according to one embodiment.

In the present discussion, the term "flexible material" refers to a material that is capable of bending, even repeatedly, without breaking. In other words, the term "flexible material" refers to a non-rigid, yielding material capable of withstanding external stresses of compression, traction, or bending without breaking.

The term "flexible material having elastic behavior" means a flexible material which, if subjected to external stresses, is elastically deformed and, once the external stress has ceased to be applied, returns to the original shape and dimensions thereof without damaging the initial structure. Therefore, in the description provided hereinafter, the term "elastic material" refers to an elastically deformable material. It is therefore emphasized that in this discussion the term "elastic" does not correspond to a synonym for "flexible".

With reference to the accompanying figures, a flexible printed circuit is indicated with the numeral 1, whilst the numeral 900 indicates an electronic assembly comprising the flexible printed circuit 1.

The flexible printed circuit 1 extends between a first connection end 11 and a second connection end 12. In other words, the first connection end 11 and the second connection end 12 define the ends wherebetween the flexible printed circuit 1 develops.

Preferably, the first connection end 11 and the second connection end 12 define a circuit length Lc.

According to a preferred embodiment, the flexible printed circuit 1 is laterally delimited by a first lateral edge 13 and a second lateral edge 14. The first lateral edge 13 and the second lateral edge 14 define a circuit width Wc.

According to a preferred embodiment, the circuit length Lc is greater than the circuit width Wc in such a way as to define a substantially rectangular shape of the flexible printed circuit 1.

According to the invention, the flexible printed circuit 1 comprises a support layer 101 and a conductive layer 102.

Preferably, the support layer 101 is made of an insulating material.

The number of support layers and the number of conductive layers depends on the specific application of the flexible printed circuit 1, for example depending on the nature of the electronic devices whereto it is connectable.

According to one embodiment, the flexible printed circuit 1 has a conductive layer 102, and it is called a "one-layer flexible printed circuit" or "single-sided flexible printed circuit".

According to one embodiment, the flexible printed circuit 1 has two conductive layers, and it is called a "two-layer flexible printed circuit" or "double-sided flexible printed circuit".

According to a further embodiment, the flexible printed circuit 1 has a number of conductive layers between 4 and 8, and it is called a "multi-layer flexible printed circuit".

According to a preferred embodiment, the flexible printed circuit 1 is obtained starting from a support layer 101 whereupon at least one conductive layer 102, preferably made of copper, is laminated. By means of a silkscreen or photography process a drawing of the desired circuit is produced upon the at least one conductive layer 102. The flexible printed circuit is subsequently engraved by means of a chemical process thereby leaving only the circuit representing the electrical tracks.

According to the embodiment wherein the conductive layers are at least two, the conductive layers are interconnected by means of internally metallized holes by means of a chemical process or a galvanic process. In other words, the flexible printed circuit consists of the alternation of support layers and conductive layers, pressed together, wherein the connections between the different conductive layers are made by means of holes, either through holes or blind holes, internally metallized by means of a chemical or galvanic process.

According to one embodiment, a photosensitive product that is resistant to engraving liquids, called "resist" or "dry-film", such as acid or alkali liquids, is first applied to the at least one conductive layer. If the photosensitive product is in the form of a liquid or paste, it is applied by means of a spraying process or by means of a silkscreen; otherwise, if the photosensitive product is of the "dry-film" type, it is laminated onto the conductive layer. The photosensitive product is subsequently subjected to a desired design by means of photography and developed in order to obtain a protective outline that is applied to the conductive layer. Finally, by means of chemical etching, the metal forming the conductive layer is exposed within those areas that are not covered by the protective outline.

According to one embodiment, the electrical connection between the various conductive layers is obtained by means of holes that are internally metallized using a chemical or galvanic process. The insides of the holes are preferably initially coated with a thin layer of a conductive polymer, for example 3,4-ethylenedioxythiophene or a cation-containing resin, such as SN2+. More preferably, a galvanic accretion of copper is performed upon such a conductive polymer.

According to one embodiment, electronic components are mounted upon one or both conductive layers of the flexible printed circuit 1, and connections are made to external printed circuits.

According to one embodiment, the connections of said electronic components and the outward connections are made by means of a mild brazing process using a tin-based alloy. According to one embodiment, the brazing process is manual. The brazing process is preferably automated.

According to one embodiment, the brazing process is wave brazing, selective wave brazing, or by means of the remelting of a special solder paste deposited by screen printing.

According to a preferred embodiment, the flexible printed circuit 1 comprises a second support layer 101a that is suitable for engaging with the conductive layer 102 at an opposite position in relation to the support layer 101.

According to such embodiment, the flexible printed circuit 1 consists of a support layer 101, a conductive layer 102, and a second support layer 101a that engages the conductive layer 102 in such a way as to create a layered structure. In other words, the conductive layer 102 is arranged between the two support layers 101, 101a. In still other words, the conductive layer 102 is sandwiched between the two support layers 101, 101a.

According to a preferred embodiment, at a conductive layer 102, the flexible printed circuit 1 comprises two support layers 101, 101a adapted to protect a respective conductive layer 102.

According to one embodiment, the conductive layers consist of copper sheets having a conductive layer thickness of between 17 and 105 microns.

According to a further embodiment, the conductive layers are made of aluminum, or else using copper, silver, or carbon-based paints applied by means of a silkscreen or photography process.

According to one embodiment, the support layers have a support layer thickness of between 12 and 350 microns.

According to one embodiment, surface treatments are carried out on the outer layers in order to improve the appearance thereof and/or in order to protect the copper from oxidation.

According to the invention, the support layer 101 has an elastic behavior, i.e., the support layer 101 is made of an elastically deformable material. The elastically deformable support layer 101, if subjected to external stress, is able to deform between a first configuration and a second configuration and to return to the initial condition once the external stress is interrupted, without damaging the structure. According to such aspect of the invention, the flexible printed circuit 1 is elastically deformable between a resting configuration and a working configuration.

According to an embodiment comprising a plurality of support layers 101, all of said support layers 101 have an elastic behavior, i.e. the support layers 101 are made of an elastically deformable material. The elastically deformable support layers 101, if subjected to external stress, is able to deform between a first configuration and a second configuration and to return to the initial condition once the external stress is interrupted, without damaging the structure. According to such aspect of the invention, the flexible printed circuit 1 is elastically deformable between a resting configuration and a working configuration.

In the resting configuration, the first connection end 11 and the second connection end 12 are at a resting distance Dr.

In the working configuration, the first connection end 11 and the second connection end 12 are at a working distance Dl different from the resting distance Dr.

According to the invention, the flexible printed circuit 1 is able to elastically return to the resting configuration.

As described above, the flexible printed circuit 1 has an elastic behavior, i.e., it is elastically deformable, comprising a support layer 101 having an elastic behavior. In particular, the flexible printed circuit 1, following the application of external stress, is able to elastically deform between a resting configuration and a working configuration. Once the application of the external stress has terminated, the flexible printed circuit 1 returns to the resting configuration without damaging the initial structure. Therefore, the circuit length Lc and the circuit width Wc remain unchanged in the resting configuration and in the working configuration.

According to one embodiment, the flexible printed circuit 1 has an elastic behavior, i.e., it is elastically deformable, comprising at least one support layer 101 having an elastic behavior.

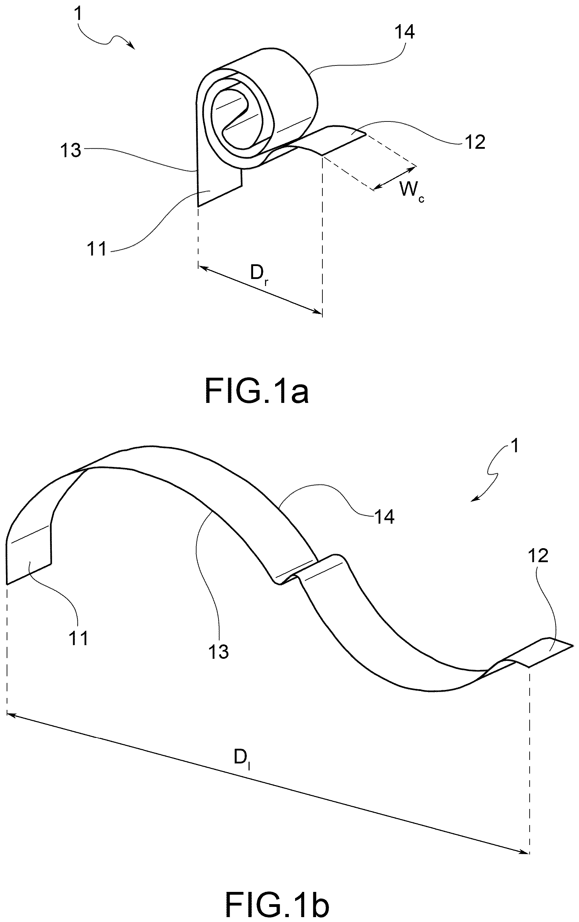

According to a first embodiment, shown by way of example in Figure 1a and 1b, in the resting configuration, the resting distance Dr is less than the working distance Dl. According to such embodiment, in the working configuration, the working distance Dl is greater than the resting distance Dr.

According to this first embodiment, the external stress imparted to the flexible printed circuit 1 causes the second connection end 12 to move away from the first connection end 11, thereby causing an increase in the mutual distance between said first connection end 11 and second connection end 12, from the resting distance Dr to the working distance Dl. In other words, in the working configuration, the working distance Dl is greater than the resting distance Dr.

According to one embodiment, the flexible printed circuit 1, in the resting configuration, has an undulating or spiral shape.

According to a preferred embodiment, the support layer 101, in the resting configuration, has an undulating or spiral shape.

According to one embodiment, the support layer 101 is made of a material suitable for being preformed, for example it is made of a polyester-based or polyamide-based material.

According to one embodiment, at least one support layer 101 is made of a material that is suitable for being preformed, for example it is made of a polyester-based material.

According to a preferred embodiment, each support layer 101 is made of a material that is suitable for being preformed, for example it is made of a polyester-based material.

According to a preferred embodiment, the support layer 101 is made of a polyester-based material, such as polyethylene PE or polyethylene terephthalate PET or polyethylene naphthalate PEN or polytetrafluoroethylene PTFE or polycarbonate PC.

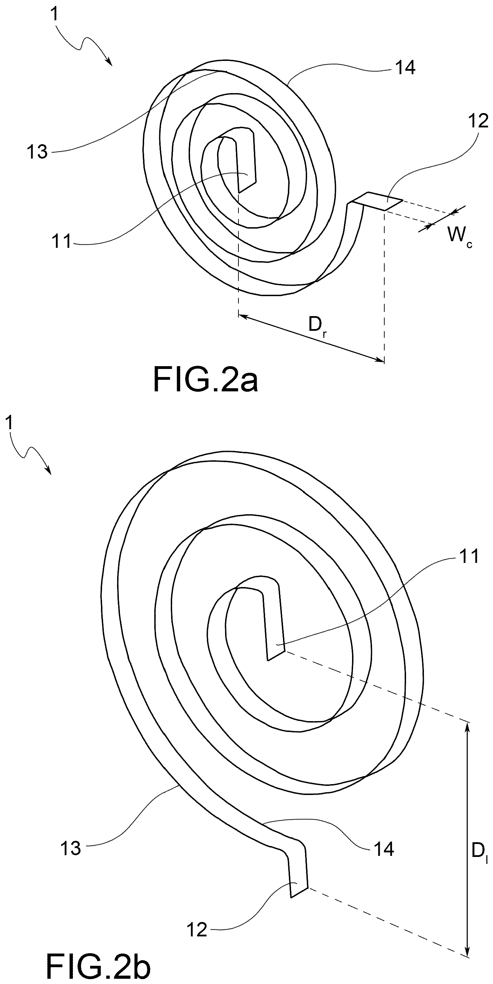

According to a preferred embodiment, the support layer 101 is made of a material suitable for being preformed, i.e., a material suitable for being subjected to a thermoforming process or to a thermal preforming process, described in detail below. By means of said thermoforming process, spiral shapes are obtained, such as, for example, a simple spiral, as shown by way of example in Figure 2a, or a double barred spiral, as shown by way of example in Figure 1a, or a flat helix or conical helix.

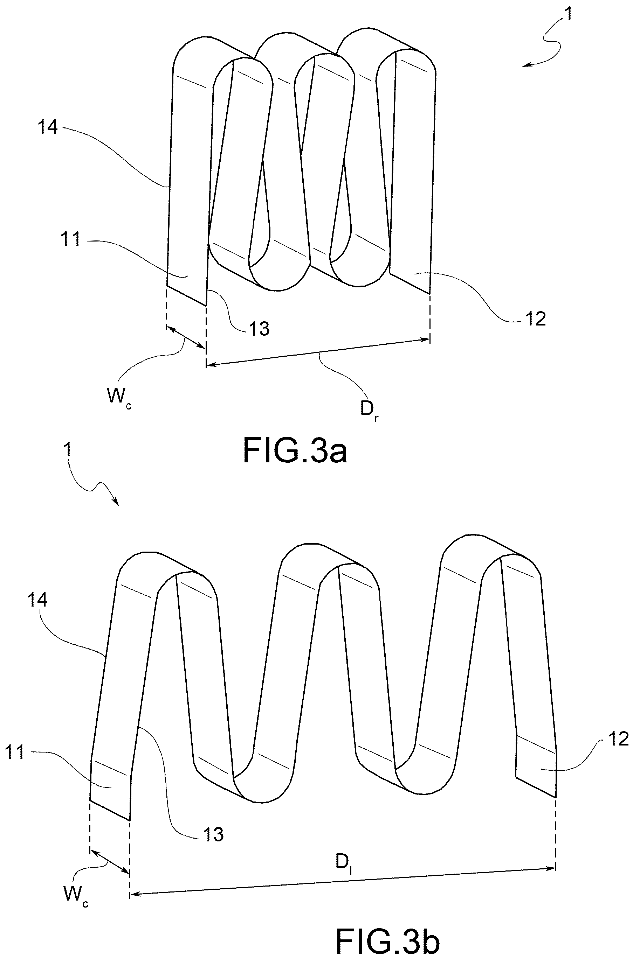

Furthermore, the preforming process allows for undulating shapes, such as, for example, a sinusoidal wave, to be made as shown by way of example in Figure 3a, or sawtooth shapes.

According to a second preferred embodiment, the support layer 101 is made of a material that is suitable for being preformed, for example it is made of a polyamide-based material, such as polyamide film PI or aromatic polyamide or aliphatic polyamide, such as, for example, poly(4,4'-oxyphenylene-pyromellitimide).

According to a third preferred embodiment, the support layer 101 is made of a material that is suitable for being preformed, such as, for example, polyvinyl chloride PVC or polyvinyl fluoride PVF or polyvinylidene fluoride PVDF. According to such an embodiment, the support layer 101 is made of a material suitable for being preformed in order to produce spiral shapes, such as, for example, a simple spiral or a double-barred spiral or flat helix or conical helix.

According to one embodiment, flexible printed circuits made of a polyamide-based material have the shape at rest of a flat circuit. In other words, flexible printed circuits wherein the support layer 101 is made of a polyamide-based material have a resting configuration corresponding to that of a flat flexible printed circuit.

According to one embodiment, flexible printed circuits made of polyester-based material have, as the resting shape thereof, that of a flat circuit. In other words, flexible printed circuits wherein the support layer 101 is made of a polyester-based material have a resting configuration corresponding to that of a flat flexible printed circuit.

According to one embodiment, the support layer 101 is made of a material suitable for being preformed, such as polyvinyl chloride PVC, polyvinyl fluoride PVF, polystyrene fluoride PVDF.

According to a further embodiment, the flexible printed circuits based on polyvinyl chloride PVC or polyvinyl fluoride PVF or polyvinylidene fluoride PVDF have, as the resting shape thereof, that of a flat circuit. In other words, flexible printed circuits based on polyvinyl chloride PVC or polyvinyl fluoride PVF or polyvinylidene fluoride PVDF have a resting configuration corresponding to that of a flat flexible printed circuit.

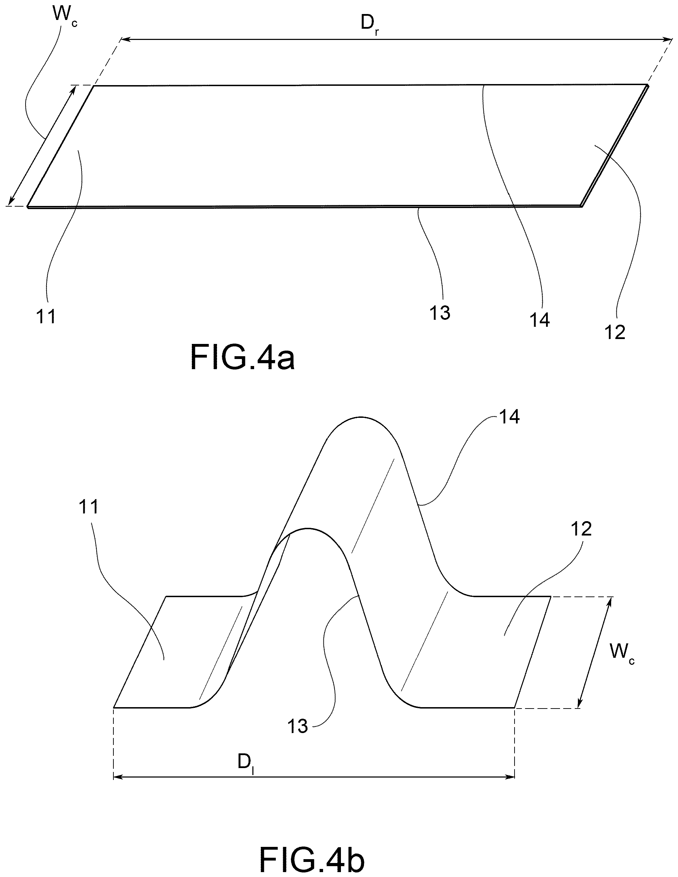

According to a fourth embodiment shown by way of example in Figure 4a and 4b, in the resting configuration, the resting distance Dr is greater than the working distance Dl. According to this fourth embodiment, in the working configuration, the working distance Dl is less than the resting distance Dr.

The object of the present invention is also an electronic assembly 900 that comprises a first device 901, a second device 902, and a flexible printed circuit 1, which electrically connects the first device 901 to the second device 902. In other words, the flexible printed circuit 1 is suitable for electrically connecting the first device 901 and the second device 902.

According to one embodiment, the first connection end 11 comprises a first connection terminal, and the second connection end 12 comprises a second connection terminal.

According to one embodiment, the first device 901 comprises a first connection portion 9011, and the second device 902 comprises a second connection portion, which house the first connection terminal of the first connection end 11 and the second connection terminal of the second connection end 12, respectively. Preferably, the electrical connection between the first connection terminal and the first connection portion and the electrical connection between the second connection terminal and the second connection portion is obtained by means of connection means, for example electrical connectors.

According to a preferred embodiment, the electronic assembly 900 is configurable in an initial configuration and in a stress configuration.

In the initial configuration, the first device 901 and the second device 902 are positioned at a predefined initial distance Di.

In the stress configuration, the first device 901 and the second device 902 are positioned at a predefined stress distance Ds that is different from the initial distance Di.

According to a preferred embodiment, the initial configuration of the electronic assembly 900 corresponds to the resting configuration of the flexible printed circuit 1. In other words, with the electronic assembly 900 in the initial configuration, the flexible printed circuit 1 is in the resting configuration, i.e. the flexible printed circuit is not subjected to any external stress. Conversely, with the electronic assembly 900 in the stress configuration, the flexible printed circuit 1 is in the working configuration, i.e. the flexible printed circuit 1 is elastically deformed by the application of external stress.

According to a preferred embodiment, in the initial configuration, the resting distance Dr between the first connection end 11 and the second connection end 12 of the flexible printed circuit 1 is less than or substantially equal to the initial distance Di between the first device 901 and the second device 902.

According to one embodiment, the first device 901 is an auxiliary printed circuit. According to one embodiment, the second device 902 is an auxiliary printed circuit. Preferably, the auxiliary printed circuit is a rigid printed circuit whereupon electrical and electronic components are mounted, according to the type of application required.

According to one embodiment, the first device 901 is a rigid printed circuit.

According to a second embodiment, the second device 902 is a rigid printed circuit.

According to a third embodiment, the first device 901 and the second device 902 are both rigid printed circuits.

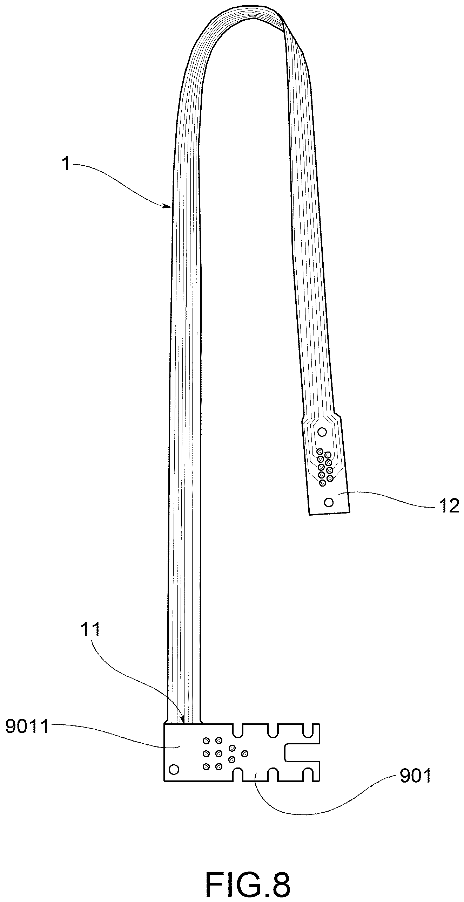

According to one embodiment, the first device 901 is a rigid printed circuit, and the second device 902 is a printer head. According to this embodiment shown by way of example in Figure 8, the connection of the first device 901 with the flexible printed circuit 1 results in the formation of a circuit called a "rigid-flexible circuit".

According to a further embodiment, the first device 901 is a main rigid control printed circuit, and the second device 902 is a movable carriage electrically connected to the first device 901 by means of the flexible printed circuit 1.

According to one embodiment, the flexible printed circuit 1 is used in cameras.

According to a further embodiment, the first device 901 is a motherboard, and the second device 902 is a display comprised in a portable computer. In particular, in said portable computer, the first device 901, i.e., the motherboard, is connected by means of the flexible printed circuit 1 to the second device 902, i.e., the display.

The present invention relates to a method for obtaining a preformed flexible printed circuit.

In the following description, the term "mold" indicates an instrument adapted to keep the printed circuit to be subjected to preforming in a predefined position. More specifically, a mold consists of a "die", i.e., a female shape, and a "punch", i.e. the corresponding male counter-profile, such that, once the die and the punch are coupled together, there remains a gap for housing the printed circuit. Depending on the complexity of the shape to be obtained by preforming, the parts making up the mold may also be more than two, while in some cases it may be composed of a single element.

The method for obtaining the flexible printed circuit comprises the following steps:
a) providing a preliminary printed circuit wherein a support layer 101 has an elastic behavior and is made of a material suitable for being thermally preformed, wherein the support layer 101 has a plastic deformation temperature Tp;
b) providing a mold having a shape corresponding to a final shape that the flexible printed circuit 1 must adopt, wherein the mold comprises a die and a punch suitable for being coupled to the die by a shape coupling;
c) arranging the preliminary printed circuit to be preformed inside the die;
d) arranging the punch having a shape complementary to that of the die in such a way as to couple it to the die by means of shape coupling, wherein the preliminary printed circuit comprises a plurality of contact portions that are in contact with the mold;
e) subjecting the preliminary printed circuit to at least one thermal cycle comprising a heating step, wherein the preliminary printed circuit is heated to a working temperature Twork substantially equal to or higher than the plastic deformation temperature Tp of the support layer 101, and a cooling step down to the ambient temperature Ta;
f) extracting the residual heat inside the mold in such a way as to cool the plurality of contact portions of the preliminary printed circuit such as to obtain the flexible printed circuit 1;
g) extracting the preformed flexible printed circuit 1 having the desired final shape.

According to one embodiment, the heating step provides for reaching and exceeding the plastic deformation temperature Tp of the support layer 101. Furthermore, the heating step involves maintaining the working temperature Twork for a predetermined period and quickly returning to the ambient temperature.

According to one embodiment, the heating step provides for reaching a first working temperature Twork1 and maintaining it for a predetermined time T1, then reaching a second working temperature Twork2, different from the first working temperature Twork1, and maintaining it for a second predetermined time T2.

According to a further embodiment, the heating step provides for reaching a third working temperature Twork3, different from the second working temperature Twork2, and maintaining it for a predetermined time T3.

According to one embodiment, the preliminary printed circuit, once positioned in the mold, comprises contact portions that are in contact with the mold and free portions that are not in contact with the mold.

According to one embodiment, the free portions are portions of the preliminary printed circuit that do not need to be preformed.

Once the punch is arranged on the die, the preliminary printed circuit comes into contact with the mold at contact portions. In other words, those portions of the preliminary printed circuit to be preformed in contact with the mold are the contact portions. Conversely, those portions of the preliminary printed circuit not in contact with the die or metal parts are the free portions.

According to a preferred embodiment, the cooling step is rapid, removing the residual heat from the mass of the mold.

According to one embodiment, the free portions of the flexible printed circuit are not subjected to either step of the at least one thermal heating and cooling cycle.

According to one embodiment, the step of preparing the preliminary printed circuit comprises a sub-step "a1" of surface treatment of the preliminary printed circuit. Preferably, the surface treatments are carried out by means of a coating using solderable resins, with tin, silver, or gold applied by means of a chemical or galvanic process.

According to a preferred embodiment, the preliminary printed circuit is a flexible printed circuit having a support layer with elastic behavior which has previously been subjected to the steps of obtaining a printed circuit. In other words, the preliminary printed circuit corresponds to a flexible printed circuit, as described above, ready to undergo a thermal preforming or thermoforming process.

According to one embodiment, the mold whereinside the flexible printed circuit to be preformed is arranged must have a shape corresponding to the final shape to must be adopted by the flexible printed circuit at the end of the thermal preforming process.

According to the embodiment shown by way of example in Figure 2a wherein the preformed flexible printed circuit has the shape of a simple spiral, the mold used for the preforming is a mandrel whereupon the preliminary printed circuit is wound and locked.

According to the embodiment shown in Figure 3a wherein the flexible printed circuit has the shape of a sinusoidal wave, the mold consists of a suitably shaped support or a clamp capable of holding the preliminary printed circuit in the final position that is to be obtained following the preforming process.

Preferably, the thermoforming or thermal preforming process provides for a thermal cycle comprising at least one heating step at a temperature substantially equal to the plastic deformation temperature of the material with elastic behavior in use followed by at least one cooling step. At the end of the thermoforming process, a flexible printed circuit is obtained, which is preformed in a desired shape and permanently maintains the shape imprinted thereupon.

Innovatively, the flexible printed circuit, the electronic assembly that comprises it, and the method for obtaining said flexible printed circuit largely fulfill the intended object by overcoming the typical problems of the prior art.

Advantageously, the elastically deformable flexible printed circuit according to the present invention electrically connects two devices positioned in mechanically non-coplanar positions.

Advantageously, the elastically deformable flexible printed circuit according to the present invention electrically connects two devices positioned in non-rigidly connected positions.

Advantageously, the elastically deformable flexible printed circuit according to the present invention is able to withstand repeated external stresses, such as traction, compression, or bending.

Advantageously, the elastically deformable flexible printed circuit according to the present invention ensures a high degree of reliability insofar as it always returns to the initial condition without suffering permanent damage that alters the mechanical behavior thereof.

Advantageously, the elastically deformable flexible printed circuit according to the present invention is preformed in order to obtain spiral or undulating shapes with a compact resting distance with respect to the working distance. Advantageously, the flexible printed circuit according to the present invention considerably reduces the overall dimensions at rest.

Advantageously, the flexible printed circuit according to the present invention returns to the initial configuration thereby preventing said circuit from impeding the mutual movement between the first device and the second device. Advantageously, the flexible printed circuit according to the present invention reduces the probability that said circuit will break.

Advantageously, the method for obtaining a flexible printed circuit according to the present invention requires a limited number of steps in order to obtain a preformed elastically deformable flexible printed circuit.

Advantageously, the flexible printed circuit according to the embodiment wherein the conductive layer is enclosed between two support layers protects the conductive layer from breakage when the flexible printed circuit is subjected to external stresses.

Advantageously, the flexible printed circuit according to the embodiment wherein the conductive layer is enclosed between two support layers protects the conductive layer during thermal preforming operations.

Advantageously, the flexible printed circuit according to the embodiment wherein the conductive layer is enclosed between two support layers ensures that the electrical properties of the conductive layer are maintained.

Advantageously, the step of preparing the preliminary printed circuit having at least one support layer with elastic behavior is carried out on panels. Advantageously, the step of preparing the preliminary printed circuit having at least one support layer with elastic behavior is carried out directly from roll to roll, allowing flexible printed circuits to be obtained that are of a significantly longer length than the printed circuits of the prior art.

Advantageously, the step of preparing the flexible printed circuit according to the invention provides for surface treatments to be carried out on the outer layers of the circuit. Advantageously, the surface treatments improve the appearance of the flexible printed circuit. Advantageously, the surface treatments protect the copper of the conductive layers from oxidation.

Advantageously, the thermal preforming step creates an elastically deformable flexible printed circuit according to the present invention with a desired shape permanently maintained during the entire life cycle thereof.

Advantageously, the method for obtaining a flexible printed circuit according to the present invention obtains complex shapes capable of also connecting miniaturized electronic components for microelectronics applications.

Advantageously, the method according to the present invention creates an elastically deformable flexible printed circuit having a compact resting shape that is easily arranged inside an electronic assembly.

Advantageously, the method according to the present invention creates flexible printed circuits comprising preformed portions wherein the behavior of the flexible printed circuit is elastic and free portions wherein the printed circuit, having not been preformed, maintains the features of the flexible printed circuit.

It is clear that a person skilled in the art may make changes to the invention described above in order to meet contingent needs, which changes all fall within the scope of protection as defined in the following claims.

## Claims

1. A flexible printed circuit (1) for electrically connecting a first device (901) and a second device (902) comprised in an electronic assembly (900),
wherein the flexible printed circuit (1) extends between a first connection end (11) and a second connection end (12) ;
wherein the flexible printed circuit (1) comprises a support layer (101) and a conductive layer (102);
wherein the support layer (101) has an elastic behavior, so that the flexible printed circuit (1) is elastically deformable between a resting configuration, wherein the first connection end (11) and the second connection end (12) are at a resting distance (Dr), and a working configuration, wherein the first connection end (11) and the second connection end (12) are at a working distance (Dl) that is different than the resting distance (Dr),
wherein the flexible printed circuit (1) is capable of elastically returning to the resting configuration.

2. Flexible printed circuit (1) according to claim 1, wherein in the resting configuration, the resting distance (Dr) is less than the working distance (Dl) and wherein, in the working configuration, the working distance (Dl) is greater than the resting distance (Dr).

3. Flexible printed circuit (1) according to claim 2, wherein the support layer (101), in the resting configuration, has an undulating or spiral shape.

4. Flexible printed circuit (1) according to any one of claims 2 to 3, wherein the support layer (101) is made of a material suitable for being preformed, for example it is made of a polyester-based or polyamide-based material.

5. Flexible printed circuit (1) according to claim 1, wherein, in the resting configuration, the resting distance (Dr) is greater than the working distance (Dl) and wherein, in the working configuration, the working distance (Dl) is greater than the resting distance (Dr).

6. Flexible printed circuit (1) according to claim 5, wherein the support layer (101) is made of a material suitable for being preformed, for example it is made of a polyamide-based or polyester-based material.

7. Flexible printed circuit (1) according to claim 2 or claim 3 or else claim 5, wherein the support layer (101) is made of a material suitable for being preformed, such as polyvinyl chloride PVC, polyvinyl fluoride PVF, polyvinylidene fluoride PVDF, for example.

8. Flexible printed circuit (1) according to any one of the preceding claims, comprising a second support layer (101a) suitable for being engaged with the conductive layer (102) in an opposite position with respect to the support layer (101).

9. An electronic assembly (900) comprising:
- a first device (901);
- a second device (902);
- a flexible printed circuit (1) according to any one of the preceding claims electrically connecting the first device (901) to the second device (902);
wherein the electronic assembly (900) is configurable in an initial configuration, wherein the first device (901) and the second device (902) are positioned at a predefined initial distance (Di), and a stress configuration, wherein the first device (901) and the second device (902) are positioned at a predefined stress distance (Ds) that is different from the initial distance (Di) .

10. Electronic assembly (900) according to claim 9, wherein in the initial configuration, the resting distance (Dr) between the first connection end (11) and the second connection end (12) of the flexible printed circuit (1) is less than or substantially equal to the initial distance (Di) between the first device (901) and the second device (902).

11. Electronic assembly (900) according to any one of the claims from 9 to 10, wherein the first device (901) and/or the second device (902) is an auxiliary printed circuit.

12. A method for obtaining a flexible printed circuit (1) according to any one of the preceding claims, comprising the following steps:
a) providing a preliminary printed circuit wherein a support layer (101) has an elastic behavior and is made of a material that is suitable for being thermally preformed, wherein the support layer (101) has a plastic deformation temperature (Tp);
b) providing a mold having a shape corresponding to a final shape that the flexible printed circuit (1) must adopt, wherein the mold comprises a die and a punch suitable for being coupled to the die by shape coupling;
c) arranging the preliminary printed circuit to be preformed inside the die;
d) arranging the punch having a shape complementary to that of the die in such a way as to couple it to the die by means of shape coupling, wherein the preliminary printed circuit comprises a plurality of contact portions that are in contact with the mold;
e) subjecting the preliminary printed circuit to at least one thermal cycle comprising a heating step, wherein the preliminary printed circuit is heated to a working temperature (Twork) substantially equal to or higher than the plastic deformation temperature (Tp) of the support layer (101), and a cooling step down to the ambient temperature (Ta);
f) extracting the residual heat from inside the mold in such a way as to cool the plurality of contact portions of the preliminary printed circuit such as to obtain the flexible printed circuit (1);
g) extracting the preformed flexible printed circuit (1) having the desired final shape.
